# EUROPEAN PATENT APPLICATION

(11) **EP 4 546 436 A1**
(43) Date of publication of application: **30.04.2025**
(21) Application number: 23831128.6
(22) Date of filing: 15.06.2023
(51) Int. Cl.: H01L 33/22, H01L 21/02, H01L 33/00

(54) **BONDED LIGHT-EMITTING ELEMENT WAFER AND PRODUCTION METHOD THEREFOR**

(30) Priority: 27.06.2022 JP 2022103043
(71) Applicant: Shin-Etsu Handotai Co., Ltd., Tokyo 100-0004 (JP)
(72) Inventor: ISHIZAKI, Junya, Annaka-shi, Gunma 379-0196 (JP); AKIYAMA, Tomohiro, Annaka-shi, Gunma 379-0196 (JP)
(74) Representative: Röthinger, Rainer
(86) International application number: PCT/JP2023/022251
(87) International publication number: WO 2024/004680

(57) **Abstract**

The present invention is a bonded light-emitting device wafer including an epitaxial wafer for a light-emitting device including an epitaxial layer that includes an active layer, a transparent substrate with both visible light-transmissive and ultraviolet light-transmissive, and the epitaxial wafer and the transparent substrate being bonded via an adhesive layer with both visible light-transmissive and ultraviolet light non-transmissive, in which a protruding height of a spike-shaped inclusion, which is inherently present in the epitaxial layer, from the epitaxial layer is equal to or less than a thickness of the adhesive layer. This provides the bonded light-emitting device wafer having a narrow failure portion area generated by the spike-shaped inclusion, in which the bonded light-emitting device wafer includes the epitaxial wafer having the spike-shaped inclusion thereon and a transparent substrate with both visible light-transmissive and ultraviolet light-transmissive are bonded via the adhesive layer with both visible light-transmissive and ultraviolet light non-transmissive.

## Description

### TECHNICAL FIELD

The present invention relates to a bonded light-emitting device wafer and a method for producing the same.

### BACKGROUND ART

Conventionally, a technique for a bonded wafer via BCB (benzocyclobutene) (Bonded light-emitting device wafer) as a wafer for an AlGaInP-based µ-LED (micro-LED) is disclosed (e.g., Patent Document 1).

In the bonded wafer described above, due to the bonding of two wafers together, surface conditions of each wafer (for example, a substrate having an AlGaInP-based light-emitting device layer and a to-be-bonded substrate to be bonded to a former substrate), or existence of foreign matters present on a bonding interface may cause a bonding failure portion.

### CITATION LIST

### PATENT LITERATURE

Patent Document 1: JP 2022-013244 A

### SUMMARY OF INVENTION

### TECHNICAL PROBLEM

In particular, an epitaxial wafer is used for one of two wafers to be bonded, thus presence of a protrusion-shaped failure portion generated by a foreign matter that falls during growth of an epitaxial layer of the epitaxial wafer is a problem. The most of sources of the foreign matter that fall during the growth are attributed to a precipitate in an epitaxial growth furnace. Although a gas containing raw material is continually supplied from a raw material gas inlet of the epitaxial growth furnace during growth, it is difficult to completely shield radiant heat from a heating unit at the inlet, resulting in decomposition and precipitation of a trace of the raw material gas at the inlet.

This precipitate is not a semiconductor and is precipitated in a state close to metal. In particular, the precipitate having In or Ga as a main component has a low melting point and this melting point is almost the same or lower than a decomposition temperature of organic metals used for raw materials. Consequently, the precipitate is in a state of being constantly prone to exfoliating from the inlet during growth. The precipitate exfoliated from the inlet is transported by a carrier gas and falls on a surface of the epitaxial layer. When exfoliated, because of exfoliating along a carrier gas flow direction, the majority of precipitate has a spear-like shape and pierces into the surface of the epitaxial layer while maintaining this shape.

Therefore, the precipitate that falls on the epitaxial surface pierces into the epitaxial surface in a state having a size (height) of several to tens of µm, and the epitaxial growth is performed as it is while forming an abnormal growth portion around the precipitate. In the case of a small precipitate, the precipitate either becomes buried along with epitaxial growth to form a hillock or causes growth inhibition to form the hillock; however, a large precipitate ranging several tens of µm is not buried in the epitaxial layer, and remains as the abnormal growth portion having a spike-shaped protrusion portion after the epitaxial growth.

Hereinafter, this precipitate is referred to as "spike-shaped inclusion" or simply referred to as "inclusion". When bonding or adhering, the epitaxial wafer having the spike-shaped inclusion to a to-be-bonded substrate, the inclusion is highly brittle in terms of mechanical properties, and thus, fractured by applied pressure when bonding. As a result of fracturing, particles are scattered around the inclusion, and the bonding or adhesion is performed in a state where the scattered particles are sandwiched between interfaces.

When the to-be-bonded substrate or the bonding / adhesive layer is composed of a light non-transmissive material that does not transmit light such as metal, the particles sandwiched by the bonding / adhesive interface are mere problems on the mechanical strength of the bonding / adhesive interface, and are not problems as long as the particles are in a degree where any problem is not generated during device processing or dice processing.

However, when the to-be-bonded substrate and the bonding / adhesive layer are composed of a light-transmissive material, particles present in the bonding / adhesive interface become a cause of generating light absorption as well as generating light scattering. There is a clear characteristic deference in a chip corresponding to a location where light scattering or absorption is increased relative to an adjacent chip, and thus uniformity of distribution of the characteristics of the device formed in the wafer is decreased, resulting in a decrease in yield.

In addition, the particles scattered by fracturing this spike-shaped inclusion (spike-shaped protrusion portion) are scattered in a relatively wide area. Therefore, a bonding failure portion spreads beyond the effect of the height of spike-shaped inclusion, thereby reducing the yield.

Patent Document 1 discloses a technique for bonding an epitaxial wafer having unevenness (protrusion-shaped) on a surface to a to-be-bonded wafer. However, the technique disclosed in Patent Document 1 is the technique when the protrusion portion (unevenness) is formed almost uniformly over an entire surface of the wafer and is not a technique disclosure for solving a problem that arises during bonding to the protrusion-shaped portion that is present in discrete, irregular and spike-shaped.

The present invention has been made in view of the above-described problem. An object of the present invention is to provide a bonded light-emitting device wafer having a narrow failure portion area generated by the spike-shaped inclusion, in which the bonded light-emitting device wafer includes the epitaxial wafer having the spike-shaped inclusion thereon bonded to a transparent substrate with both visible light-transmissive and ultraviolet light-transmissive via the adhesive layer with both visible light-transmissive and ultraviolet light non-transmissive. The object is also to provide a method for producing a bonded light-emitting device wafer in which the particles originating from the inclusions during bonding is suppressed and the area of the failure portion generated by the spike-shaped inclusion is narrow.

### SOLUTION TO PROBLEM

The present invention has been made in view of the above-described problem. An object of the present invention is to provide a bonded light-emitting device wafer comprising:
an epitaxial wafer for a light-emitting device comprising an epitaxial layer that includes an active layer;
a transparent substrate with both visible light-transmissive and ultraviolet light-transmissive; and
the epitaxial wafer and the transparent substrate being bonded via an adhesive layer with both visible light-transmissive and ultraviolet light non-transmissive, wherein
a protruding height of a spike-shaped inclusion, which is inherently present in the epitaxial layer, from the epitaxial layer is equal to or less than a thickness of the adhesive layer, and
a tip portion of the spike-shaped inclusion is fractured.

Such a bonded light-emitting device wafer has the protrusion of the inclusion portion present in a spike-shape on a surface of the epitaxial wafer that is equal to or less than the thickness of the adhesive layer. As a result, spread of a bonding failure portion can be suppressed, thereby an area of the bonding failure portion can be reduced.

In this event, the adhesive layer is preferably selected from the group consisting of benzocyclobutene, silicone resin, epoxy resin, SOG (Spin-on-glass, spin on glass), polyimide, and amorphous fluoropolymer.

Such materials like these are suitable as the material for the adhesive layer of the bonded light-emitting device wafer.

Moreover, the present invention provides a method for producing a bonded light-emitting device wafer, the method comprising the steps of:
producing an epitaxial wafer for a light-emitting device having an epitaxial layer including an active layer on a starting substrate;
providing a transparent substrate with both visible light-transmissive and ultraviolet light-transmissive; and
bonding the epitaxial wafer for the light-emitting device and the transparent substrate via an adhesive layer with both visible light-transmissive and ultraviolet light non-transmissive, wherein
before the step of bonding, the epitaxial layer of the epitaxial wafer is faced to a dummy wafer via a protective film, and pressure is applied thereon,
a tip portion of a protruding portion from the epitaxial layer of a spike-shaped inclusion inherently present in the epitaxial layer is then fractured to a protruding height from the epitaxial layer equal to or less than a thickness of an adhesive layer, and the protruding height from the epitaxial layer of the spike-shaped inclusion is decreased, and
the step of bonding is performed by using the epitaxial wafer in which height of the spike-shaped inclusion from the epitaxial layer is decreased.

According to such a method for producing a bonded light-emitting device wafer, the tip portion of the spike-shaped inclusion can be fractured in advance, thus it is possible to produce the bonded light-emitting device wafer, in which the particles originating from the inclusions during bonding is suppressed and the area of the failure portion generated by the spike-shaped inclusion is narrow.

In this case, the protective film can have a thickness of 0.01 µm or more and 10 µm or less.

According to such a protective film thickness, the fracture of the spike-shaped inclusion can be effectively performed.

Further, in this case, the protective film preferably has a thickness of 0.05 µm or more and 10 µm or less.

According to such a protective film thickness, it is possible that the fracture of the spike-shaped inclusion is performed effectively and damage to the epitaxial layer surface is suppressed.

In addition, in the inventive method for producing a bonded light-emitting device wafer, the adhesive layer is preferably selected from the group consisting of benzocyclobutene, silicone resin, epoxy resin, SOG, polyimide, and amorphous fluoropolymer.

Such materials like these can be suitably used as the material for the adhesive layer of the bonded light-emitting device wafer.

### ADVANTAGEOUS EFFECTS OF INVENTION

The inventive bonded light-emitting device wafer has the protrusion of the inclusion portion, present in a spike shape on the surface of the epitaxial wafer, which is equal to or less than the thickness of the adhesive layer. As a result, the spread of the bonding failure portion can be suppressed, thereby the area of the bonding failure portion can be reduced.

Moreover, in the inventive method for producing a bonded light-emitting device wafer, it is possible to produce the bonded light-emitting device wafer in which the particles originating from the inclusions during bonding is suppressed and the area of the failure portion generated by the spike-shaped inclusion is narrow. In particular, by fracturing the inclusion portion present in a spike-shape on the surface of the epitaxial wafer before bonding, the number of particles attributed to the inclusion portion, which is generated at bonding, can be reduced. Furthermore, by fracturing the inclusion portion present in the spike-shape on the surface of the epitaxial wafer, the area of the bonding failure portion can be reduced.

### BRIEF DESCRIPTION OF DRAWINGS

FIG. 1 is a schematic cross-sectional view illustrating a part of the first embodiment of a method for producing a bonded light-emitting device wafer according to the present invention.
FIG. 2 is a schematic cross-sectional view illustrating another part of the first embodiment of a method for producing a bonded light-emitting device wafer according to the present invention.
FIG. 3 is a schematic cross-sectional view illustrating another part of the first embodiment of a method for producing a bonded light-emitting device wafer according to the present invention.
FIG. 4 is a schematic cross-sectional view illustrating another part of the first embodiment of a method for producing a bonded light-emitting device wafer according to the present invention.
FIG. 5 is a schematic cross-sectional view illustrating another part of the first embodiment of a method for producing a bonded light-emitting device wafer according to the present invention.
FIG. 6 is a schematic cross-sectional view illustrating another part of the first embodiment of a method for producing a bonded light-emitting device wafer according to the present invention.
FIG. 7 is a schematic cross-sectional view illustrating another part of the first embodiment of a method for producing a bonded light-emitting device wafer according to the present invention.
FIG. 8 is a schematic cross-sectional view illustrating another part of the first embodiment of a method for producing a bonded light-emitting device wafer according to the present invention.
FIG. 9 is a schematic cross-sectional view illustrating another part of the first embodiment of a method for producing a bonded light-emitting device wafer according to the present invention.
FIG. 10 is an enlarged photograph showing a bonding state at an inclusion portion after performing treatment in a method for producing a bonded light-emitting device wafer according to the present invention.
FIG. 11 is an enlarged photograph showing a bonding state at an inclusion portion in a conventional method for producing a bonded light-emitting device wafer.
FIG. 12 is a graph showing the width of a failure area of a BCB thickness in Examples and Comparative Example.

### DESCRIPTION OF EMBODIMENTS

Hereinafter, the present invention will be described in detail. However, the present invention is not limited thereto.

The inventive bonded light-emitting device wafer includes an epitaxial wafer for a light-emitting device including an epitaxial layer that includes an active layer, a transparent substrate with both visible light-transmissive and ultraviolet light-transmissive, and the epitaxial wafer and the transparent substrate being bonded via an adhesive layer with both visible light-transmissive and ultraviolet light non-transmissive, in which a protruding height of a spike-shaped inclusion, which is inherently present in the epitaxial layer, from the epitaxial layer is equal to or less than a thickness of the adhesive layer. In the inventive bonded light-emitting device wafer, in particular, a tip portion of the spike-shaped inclusion is fractured.

Such a bonded light-emitting device wafer can be produced by the inventive method for producing a bonded light-emitting device wafer. The inventive method for producing a bonded light-emitting device includes the steps of producing an epitaxial wafer for a light-emitting device having an epitaxial layer including an active layer on a starting substrate, providing a transparent substrate with both visible light-transmissive and ultraviolet light-transmissive, and bonding the epitaxial wafer for the light-emitting device and the transparent substrate via an adhesive layer with both visible light-transmissive and ultraviolet light non-transmissive, in which before the step of bonding, the epitaxial layer of the epitaxial wafer is faced to a dummy wafer via a protective film, and pressure is applied thereon, a tip portion of a protruding portion from the epitaxial layer of a spike-shaped inclusion inherently present in the epitaxial layer is then fractured, a protruding height from the epitaxial layer of a spike-shaped inclusion is decreased, and the step of bonding is performed by using the epitaxial wafer in which height of the spike-shaped inclusion from the epitaxial layer is decreased. In the inventive method for producing a bonded light-emitting device wafer, in particular, the fracture of the tip portion of the protruding portion from the epitaxial layer is performed until when the protruding height from the epitaxial layer reaches the thickness of the adhesive layer or less. Note that in the present invention, "bond" refers to joining two wafers together using adhesive and the like and a concept including "adhesion" or "adhesive bonding".

Hereinafter, an aspect of the inventive method for producing a bonded light-emitting device wafer is described by exemplifying the first embodiment, the second embodiment, and the third embodiment. Similar components in each embodiment are described using the same reference sign in the drawings. In addition, overlapping descriptions are omitted.

### [First Embodiment]

First, the first embodiment is described.

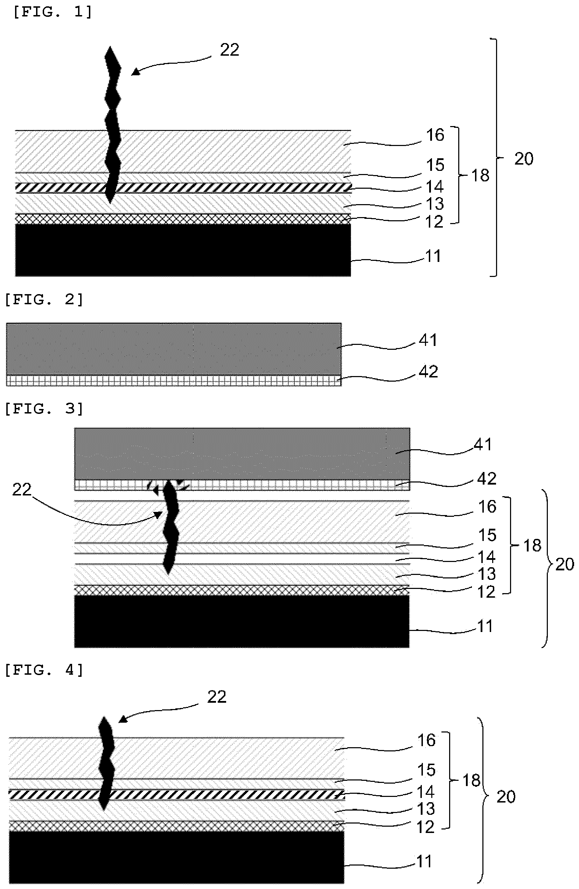

First, as shown in FIG. 1, epitaxial growth is performed sequentially on a starting substrate 11 to form each layer in order to produce an epitaxial wafer 20. Consequently, an epitaxial layer 18 including an etching stop layer 12 and an active layer 14 is grown. More specifically, the epitaxial growth of each layer can be performed as below.

As shown in FIG. 1, an etching stop layer 12 is epitaxially grown on a first conductivity-type starting substrate 11 made of, e.g., GaAs. The etching stop layer 12 can be formed, for example, after stacking a first conductivity-type GaAs buffer layer, followed by growing a first conductivity-type GaₓIn₁₋ₓP (0.4≤x≤0.6) first etching stop layer of, e.g., 0.1 µm, and a first conductivity-type GaAs second etching stop layer of, e.g., 0.1 µm. Moreover, an epitaxial wafer 20 for a light-emitting device (hereinafter, may be simply referred to as "epitaxial wafer" for short) having a light-emitting device structure as an epitaxial layer (epitaxial function layer) 18 is produced in which, for example, a first conductivity-type (Al_{y}Ga_{1-y}) ₓIn₁₋ₓP (0.4≤x≤0.6, 0.6≤y≤1.0) first cladding layer 13 of, e.g., 1.0 µm, a non-doped (Al_{y}Ga_{1-y})ₓIn₁₋ₓP (0.4≤x≤0.6, 0≤y≤0.5) active layer 14, a second conductivity-type (Al_{y}Ga_{1-y})ₓIn₁₋ₓP (0.4≤x≤0.6, 0.6≤y≤1.0) second cladding layer 15 of, e.g., 1.0 µm, a second conductivity-type GaₓIn₁₋ₓP (0.5≤x≤1.0) intermediate layer (not shown) of, e.g., 0.1 µm, and a second conductivity-type GaP window layer 16 of, e.g., 5 µm are sequentially grown on the etching stop layer 12. At this point, from the first cladding layer 13 to the second cladding layer 15 is referred to as a double-hetero (DH) structure portion. A spike-shaped inclusion 22 formed by exfoliating from an inside of a growth furnace and falling onto the epitaxial wafer 20 is present on the epitaxial wafer 20 (see FIG. 1).

In the description of the present invention, the spike-shaped inclusion 22 refers to a foreign matter inherently present in the epitaxial layer 18 and the irregular spear-shaped inclusion as described above. The "protruding height" of the spike-shaped inclusion 22 refers to a height by which the spike-shaped inclusion 22 protrudes from a surface of the epitaxial layer 18 (in a case of FIG. 1, a surface of the window layer 16).

The film thicknesses exemplified above are just examples, and the film thickness is no more than a parameter to be changed according to the operating specifications of the device; therefore, it is needless to say that the film thickness is not limited to the thicknesses described here. Moreover, it is needless to say that there is a concept in which each layer is not a single composition layer, but has a layer of a plurality of compositions within a range of compositions shown in the example. Furthermore, it is needless to say that there is a concept in which a level of carrier concentration is not uniform in each layer but the concentration has a plurality of levels in each layer.

The active layer may be composed of a single composition or may have a structure where a plurality of barrier layers and active layers are alternatively stacked, it is needless to say that a similar function can be exhibited in each case and it is needless to say that any one of the both cases can be selected.

Although the epitaxial wafer 20 provided in this way is bonded to a transparent substrate, being a to-be-bonded wafer, as described later, in the present invention, the epitaxial layer 18 of the epitaxial wafer 20 is faced to a dummy wafer via a protective film and pressure is applied thereto before the bonding step described later.

The dummy wafer is shown in FIG. 2. A dummy wafer 41 can be, for example, a silicon wafer. In the first embodiment, a protective film 42 is formed on the dummy wafer 41 (see FIG. 2). For example, photosensitive resist can be used for the protective film 42. After coating the protective film 42 made of photosensitive resist on the dummy wafer 41, it is preferable to perform prebaking thereof by maintaining at approximately 90°C to evaporate solvent contained in the resist. The dummy wafer 41 only needs to be flat, have sufficient mechanical strength to fracture the spike-shaped inclusion 22, and be inexpensive. As for the material thereof, in addition to silicon described above, for example, quartz, GaP, GaAs, InP, GaN, SiC, and the like can be selected.

Although the photosensitive resist is exemplified as the protective film 42, any material that is required to protect a surface of the epitaxial wafer 20 and has excellent wettability can be selected. Polyvinyl acetate, wax, various resists, HogoMax (registered trademark: propylene glycol monomethyl ether and polyvinyl alcohol containing material), benzocyclobutene (BCB), amorphous fluoropolymer (for example, CYTOP (registered trademark)), silicone resin, epoxy resin, and the like can be selected.

FIG. 3 shows a state where the epitaxial layer 18 of the epitaxial wafer 20 is faced to the dummy wafer 41 via the protective film 42 and pressure is applied thereto, using the dummy wafer 41 on which the protective film 42 is formed as shown in FIG. 2.

A growth surface of the epitaxial wafer 20 (the surface having the spike-shaped inclusion 22) is faced to a surface having the protective film 42 of the dummy wafer 41 and pressure is applied to the epitaxial wafer in the same way as in the procedure at bonding described later to press the epitaxial wafer against the dummy wafer 41 (see FIG. 3). At this point, pressure is selectively applied to the spike-shaped inclusion 22 and a tip portion is fractured and height is decreased. Out of the height of the inclusion 22, a part that strikes against the dummy wafer 41 by penetrating the thickness of the protective film 42 is fractured, leaving the height of the inclusion 22 corresponding to the thickness of the protective film 42. Accordingly, to lower the remaining height, the thinner protective film 42 is suitable. Adjusting viscosity of a protective material allows for a thinner coating and the remaining height can be further reduced.

The protruding height of the inclusion 22 is 10 µm or more in many cases, then it is preferable that the protective film 42 has a thickness of at least 10 µm or less. When the thickness of the protective film 42 is equal to or more than the protruding height of the inclusion 22, pressure is not applied to the inclusion 22, as a result, the inclusion 22 is not fractured.

Meanwhile, the protective film 42 also plays a role in preventing scratches on the surface of the epitaxial wafer 20 by burying fragments (particles) generated by the fracturing of the inclusion 22 in the protective film 42, and thus when the protective film 42 is too thin, a risk to have scratches on the surface of the epitaxial wafer 20 is increased. Therefore, it is preferable that the film has a thickness of 0.05 µm or more to protect the surface of the epitaxial wafer 20.

When the thickness of the protective film 42 is thinner (for example, less than 0.05 µm), it is possible that the surface of the epitaxial wafer 20 is scratched due to the particles generated by fracturing the inclusion 22. However, the surface of the epitaxial wafer 20 is subjected to roughened treatment for purpose of improving luminance in many cases, in which case the scratches on the surface of the epitaxial wafer 20 caused by the particles are not problematic. Therefore, the protective film can be made as thin as, for example, approximately 0.01 µm.

In addition, when the remaining height of the inclusion 22 after fracturing (the protruding height from the epitaxial layer 18) is lower than the thickness of the adhesive layer at bonding in the subsequent step, the remaining portion of the inclusion is included in the adhesive layer (such as BCB) and does not collide to a to-be-bonded substrate, thus a bonding failure area is suppressed to a minimum degree. Consequently, a decrease in the bonding failure by the inclusion 22 is expected by setting the thickness of the protective film 42 less than the thickness of the adhesive layer. For example, when the adhesive layer has a thickness of 0.6 µm, it is suitable for designing the thickness of the protective film 42 less than 0.6 µm.

After the fracturing step of the inclusion 22 by the dummy wafer 41, as shown in FIG. 3, the epitaxial wafer 20 is removed from the dummy wafer 41, and the protective film 42 and remaining particles both adhered on the epitaxial wafer 20 are removed (see FIG. 4). In order to remove these, when the photosensitive resist or wax is selected as the protective film 42, cleaning is performed with an organic solvent; when water-insoluble BCB, CYTOP, or silicone is selected, cleaning is performed with a rinsing liquid such as a thinning liquid or a stripper; when watersoluble HogoMax is selected, cleaning is performed with pure water. By cleaning in this way, and removing the protective film 42 and particles, the epitaxial wafer 20 having the spike-shaped inclusion 22 with reduced height can be obtained (see FIG. 4).

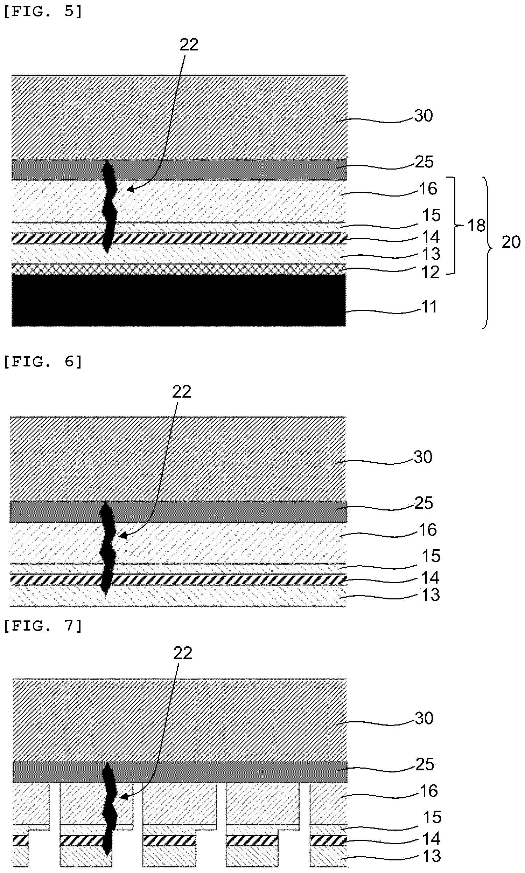

As described above, the epitaxial wafer 20 in which the protruding height of the spike-shaped inclusion 22 from the epitaxial layer 18 is reduced is bonded to a transparent substrate 30, being a to-be-bonded wafer, via an adhesive layer 25 (see FIG. 5). This bonding step can be more specifically performed in the following way.

The adhesive layer 25 with both visible light-transmissive and ultraviolet light non-transmissive is used as the adhesive layer. In the description of the present invention, ultraviolet light non-transmissive is referred to as having a light absorption edge in a wavelength range of 170 nm or more and 360 nm, with a transmissivity of 50% or less at the light absorption edge. As for the transparent substrate, being the to-be-bonded wafer, a material both visible light-transmissive and ultraviolet light-transmissive is used. As bonding material (preferably, thermosetting bonding material) with visible light-transmissive and ultraviolet light non-transmissive, for example, benzocyclobutene (BCB) is spin-coated on the epitaxial wafer 20, then the wafer is faced to and superimposed on the transparent substrate 30 (for example, sapphire wafer), being the to-be-bonded substrate, and then thermocompression-bonding is performed. Thereby, a bonded light-emitting device wafer (epitaxial wafer bonded substrate) is produced, in which the epitaxial wafer 20 and the transparent substrate 30 (for example, the sapphire wafer) are bonded to each other via the adhesive layer 25 (for example, BCB). When coating BCB by spin-coating, the designed film thickness can be, for example, 0.6 µm.

In this embodiment, a case where the to-be-bonded substrate is made of sapphire is exemplified, but any material that has flatness, visible light and UV light transmittance is sufficient, and quartz and the like can be selected.

Moreover, in this embodiment, BCB is exemplified as the bonding material to form the adhesive layer 25, but the bonding material is not limited to BCB and any material with visible light-transmissive and UV light non-transmissive can be selected. The bonding material preferably has thermosetting properties and besides BCB, silicone resin, epoxy resin, SOG, polyimide, and amorphous fluoropolymer (for example, CYTOP) may be used.

Moreover, in this embodiment, a case where the BCB is in a state of being coated in a layered shape is exemplified in FIG. 5, but it is needless to say that the BCB is not limited to the layered shape. It is needless to say the same result can be obtained by patterning photosensitive BCB to an isolated island shape, a line shape, or other shapes, and then by performing the bonding step.

As described above, the bonded light-emitting device wafer shown in FIG. 5 can be produced, in which the epitaxial wafer 20 for a light-emitting device having the epitaxial layer 18 including the active layer 14 and the transparent substrate 30 with visible light-transmissive and ultraviolet light-transmissive are bonded via the adhesive layer 25 with visible light-transmissive and ultraviolet light non-transmissive. Moreover, in the bonded light-emitting device wafer in FIG. 5, the protruding height of the spike-shaped inclusion 22, which is inherently present in the epitaxial layer 18, from the epitaxial layer 18 is equal to or less than the thickness of the adhesive layer 25.

Furthermore, the inventive bonded light-emitting device wafer can be further processed as below. As shown in FIG. 6, the starting substrate 11 is removed. Specifically, a GaAs starting substrate 11 is removed by wet etching, etc., to expose the first etching stop layer of the etching stop layer 12, and an etchant is switched to remove the second etching stop layer and thus expose the first cladding layer 13. By performing the above treatment, an epitaxial bonded substrate retaining only the DH layer and the window layer can be produced (FIG. 6). In this embodiment, the BCB thickness of 0.6 µm is exemplified, but the thickness thereof is not limited to this thickness.

In addition, as described below, device isolation can be then performed to form electrodes, etc., of each device. The following is an example of a method for the device isolating and the electrode forming and the like.

First, as shown in FIG. 7, for example, the device isolation is performed as follows. A pattern is formed by a photolithography method and the device isolation processing is performed by ICP (inductively coupled plasma). Gases used for the ICP are chlorine and argon. The ICP processing is performed twice: a step of exposing the BCB layer, and a step of exposing the second cladding layer 15.

Although this embodiment exemplifies a case in which the second cladding layer 15 is exposed, it is needless to say that the case is not limited to the case where the second cladding layer 15 is exposed. It is needless to say that the same effect can be obtained even when the GaP window layer 16 is exposed instead of the exposure of the second cladding layer 15 because a purpose of processing is achieved as long as at least the active layer 14 is isolated.

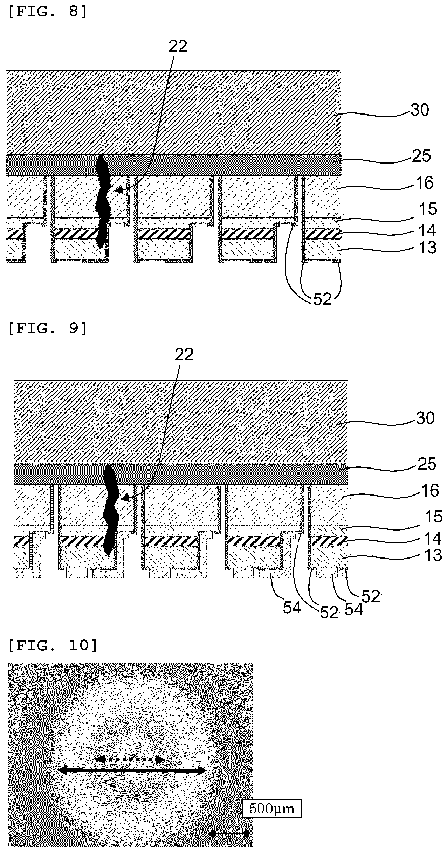

After the device isolation processing, a light-emitting device protective film 52 is formed as an end-face treatment, as shown in FIG. 8. In this embodiment, SiO₂ can be used as the light-emitting device protective film 52. The protective film is not limited to SiO₂, but any material can be selected as long as the end face can be protected and the material has insulating properties. SiNx, titanium oxide, and magnesium oxide, etc., can be selected.

Following the formation of the light-emitting device protective film 52, electrodes 54 of the device are formed, as shown in FIG. 9. For example, the electrodes 54 are formed in contact with the first conductivity-type layer or the second conductivity-type layer, respectively, and ohmic contact is then formed by performing heat treatment. In this embodiment, the first conductivity-type is designed as N-type, and the second conductivity-type is designed as P-type; a metal containing Au and Si can be used for the electrode in contact with the N-type layer, and a metal containing Au and Be can be used for the electrode in contact with the P-type layer.

In this embodiment, although the metal of, for example, Au and Si can be used for the N-type electrode, the material is not limited to this material, and the metal containing Au and Ge may be used. Moreover, the metal of, for example, Au and Be can be used for the P-type electrode, the material is not limited to this, and the metal containing Au and Zn may be used.

In this embodiment, although a case, in which the bonded wafer using the AlGaInP-based light-emitting device is used, is exemplified, it is needless to say that this embodiment is not limited to this material and function and applicable regardless of a material system when producing the bonded light-emitting device wafer bonded with the epitaxial wafer 20 in which the failure is generated due to the spike-shaped inclusion 22 (spike-shaped protruding foreign matter).

### [Second Embodiment]

Next, the second embodiment of the inventive method for producing a bonded light-emitting device wafer is described. A step and a structure up to a formation of an epitaxial wafer 20 are the same as in the first embodiment. Unlike the first embodiment, a protective film 42 is formed on a surface of the epitaxial wafer 20 (rather than a dummy wafer 41) shown in FIG. 1 (on a surface of a window layer 16 in FIG. 1), when applying pressure using the dummy wafer 41 shown in FIG. 3. By using such an epitaxial wafer 20 and dummy wafer 41, pressure is applied on the surface of the epitaxial wafer 20 via the protective film 42. A method for fracturing a spike-shaped inclusion 22 and subsequent steps are the same as in the first embodiment.

### [Third Embodiment]

Next, the third embodiment of the inventive method for producing a bonded light-emitting device wafer is described. A step and a structure up to a formation of an epitaxial wafer 20 are the same as in the first embodiment. Unlike the first embodiment, a protective film 42 is formed on an epitaxial wafer 20 shown in FIG. 1 as well as a dummy wafer 41 shown in FIG. 2 when applying pressure using the dummy wafer 41 shown in FIG. 3. That is, the protective film 42 is formed on both surfaces of the epitaxial wafer 20 (on a surface of a window layer 16 in FIG. 1) and the dummy wafer 41. In this case, by making the total thickness of the protective film (the sum of the thickness of the protective film formed on the surface of the epitaxial wafer 20 and the thickness of the protective film formed on the surface of the dummy wafer 41) not more than a thickness of an adhesive layer, it is possible to expect a reduction in bonding failure due to an inclusion 22. A method for fracturing a spike-shaped inclusion 22 and subsequent steps are the same as in the first embodiment.

In any of the first embodiment to the third embodiment, according to the present invention, it is possible to reduce the effect of the spike-shaped inclusion 22 (spike-shaped protrusion portion) during bonding, which is attributed to epitaxial growth of the epitaxial wafer 20 and is difficult to completely eliminate, and it is also possible to reduce an area of a bonding failure portion.

### EXAMPLE

Hereinafter, the present invention will be described in detail with reference to Examples and Comparative Example. However, the present invention is not limited thereto.

### (Example 1)

A bonded light-emitting device wafer was produced in accordance with the first embodiment.

First, as shown in FIG. 1, a first conductivity-type GaAs buffer layer was stacked on a first conductivity-type GaAs starting substrate 11, then a first conductivity-type GaₓIn₁₋ₓP (0.4≤x≤0.6) first etching stop layer of 0.1 µm, a first conductivity-type GaAs second etching stop layer of 0.1 µm were epitaxial grown to form an etching stop layer 12. Furthermore, a first conductivity-type (Al_{y}Ga_{1-y})ₓIn₁₋ₓP (0.4≤x≤0.6, 0.6≤y≤1.0) first cladding layer 13 of 1.0 µm, a non-doped (Al_{y}Ga_{1-y})ₓIn₁₋ₓP (0.4≤x≤0.6, 0≤y≤0.5) active layer 14, a second conductivity-type (Al_{y}Ga_{1-y})ₓIn₁₋ₓP (0.4≤x≤0.6, 0.6≤y≤1.0) second cladding layer 15 of 1.0 µm, a second conductivity-type GaₓIn₁₋ₓP (0.5≤x≤1.0) intermediate layer (not shown) of 0.1 µm, a second conductivity-type GaP window layer 16 of 5 µm were sequentially grown to provide an epitaxial wafer 20 having light-emitting device structure, being an epitaxial layer (epitaxial function layer) 18. A spike-shaped inclusion 22 formed by exfoliating from inside a growth furnace and falling onto the epitaxial wafer was present on the epitaxial wafer 20 (see FIG. 1).

Next, as shown in FIG. 2, a silicon wafer was provided as a dummy wafer 41, and photosensitive resist was coated on the dummy wafer to make a protective film 42 of 0.5 µm. After coating the resist, prebaking was performed by maintaining thereof at approximately 90°C to evaporate solvent contained in the resist.

Subsequently, as shown in FIG. 3, a growth surface of the epitaxial wafer 20 (the surface having the spike-shaped inclusion 22) was faced to and superimposed on a surface where the protective film 42 of the dummy wafer was formed, and pressure was applied to the epitaxial wafer 20 to press thereof against the dummy wafer 41.

After pressure applying treatment, as shown in FIG. 4, the epitaxial wafer 20 was removed from the dummy wafer 41, and a coating film (protective film 42) and residual particles adhered to the epitaxial wafer 20 were removed.

Next, as shown in FIG. 5, benzocyclobutene (BCB) was spin-coated onto the epitaxial wafer 20 as an adhesive layer 25 which was then faced to and superimposed on a sapphire wafer (transparent substrate 30), being a to-be-bonded substrate, and by thermally compressing, the epitaxial wafer 20 and the sapphire wafer (transparent substrate 30) were bonded via the BCB (adhesive layer 25). The designed thickness of the BCB coating was 0.6 µm.

Then, as shown in FIG. 6, the GaAs starting substrate 11 was removed by wet etching to expose the first etching stop layer and an etchant was switched to remove the second etching stop layer and thus expose the first cladding layer 13. Thereby, an epitaxial bonded substrate retaining only a DH layer and the window layer 16 was produced.

Next, as shown in FIG. 7, a pattern was formed by a photolithography method, and device isolation processing was performed by ICP. Gases used in the ICP were chlorine and argon. The ICP processing was performed twice: a step of exposing the BCB layer (adhesive layer 25), and a step of exposing the second cladding layer 15.

After the device isolation processing, as shown in FIG. 8, a light-emitting device protective film 52 made of SiO₂ was formed as an end-face treatment.

Next, as shown in FIG. 9, following the formation of the light-emitting device protective film 52, electrodes 54 were formed in contact with a first conductivity-type layer or a second conductivity-type layer, respectively, and ohmic contact was then formed by performing heat treatment. In this Example, the first conductivity-type was designed as N-type, and the second conductivity-type was designed as P-type; a metal containing Au and Si was used for the electrode in contact with N-type layer, a metal containing Au and Be was used for the electrode in contact with P-type layer.

### (Example 2)

A step and a structure up to a formation of an epitaxial wafer 20 was the same way as in Example 1. A method for fracturing a spike-shaped inclusion 22, delaminating a dummy wafer 41, cleaning an epitaxial wafer 20, bonding to a sapphire wafer (transparent substrate 30) via BCB, removing a starting substrate 11, and forming a device was the same as in Example 1 except that a protective film 42 was formed on the epitaxial wafer 20.

### (Example 3)

A step and a structure up to a formation of an epitaxial wafer 20 was the same way as in Example 1. A method for fracturing a spike-shaped inclusion 22, delaminating a dummy wafer 41, cleaning an epitaxial wafer 20, bonding to a sapphire wafer (transparent substrate 30) via BCB, removing a starting substrate 11, and forming a device was the same as in Example 1 except that protective films 42 were formed on both the epitaxial wafer 20 and a dummy wafer 41.

### (Comparative Example)

A step and a structure up to a formation of an epitaxial wafer 20 was the same way as in Examples 1 to 3. A device was produced by the same method as in Examples 1 to 3 except that fracturing treatments of a spike-shaped inclusion 22 shown in Examples 1 to 3 were not performed (i.e., a dummy wafer 41 was not used).

### (Comparison between Examples and Comparative Example)

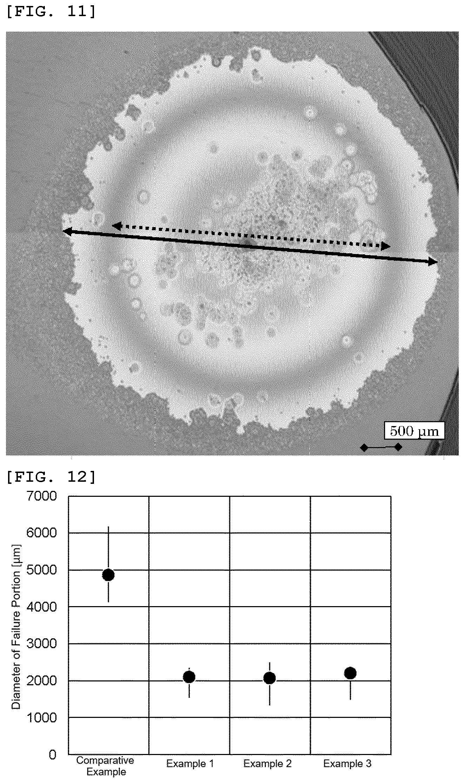

FIG. 10 shows a state of bonding at a location where the inclusion 22 after performing the treatment in Example 1 is present, and FIG. 11 shows a location where the inclusion in Comparative Example is present when bonded without modifying a conventional treatment. In any of these cases, although the inclusion is present near the center of the photographs, a coating film is not uniform at which the inclusion is present, and the film thickness near the inclusion becomes thicker. A region where such a film thickness distribution is generated (portion indicated by solid arrow) had about half diameter in Examples when compared with Comparative Example. In particular, the ratio of regions where the regions have particularly thick film thicknesses (dotted arrow portions) is one-third or less when compared with Comparative Example.

Moreover, in the conventional example (FIG. 11), a number of black spots and ring-shaped regions surrounding the black spots can be confirmed around the inclusions. The black spots are particles that are fractured and scattered inclusions during bonding treatment, and the ring-shaped regions surrounding the black spots are regions where BCB is locally thickened. Although the particles originating from the inclusions are scattered around the inclusions in the conventional example, the particles derived from such inclusions are absent or significantly decreased in Examples.

FIG. 12 shows widths of BCB thickness failure regions in Examples and Comparative Example in a case where a protective film 42 has a total thickness of 0.5 µm. In Examples 1 to 3, the diameters of the failure portions are decreased compared with Comparative Example.

The BCB protective film 42 of 0.5 µm was coated on the dummy wafer in Example 1, the BCB protective film 42 of 0.5 µm was coated on the epitaxial wafer in Example 2, and the BCB protective films 42 of 0.25 µm were coated on both the epitaxial wafer and the dummy wafer with adjusting viscosity in Example 3. The improvement effect was slightly decreased in Example 3. This is considered to be because the protective film 42 coated on both wafers resulted in the protective film 42 becoming effectively thicker than the single film being coated, thereby decreasing the effect of reducing the remaining height of the inclusion.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A bonded light-emitting device wafer comprising:
an epitaxial wafer for a light-emitting device comprising an epitaxial layer that includes an active layer;
a transparent substrate with both visible light-transmissive and ultraviolet light-transmissive; and
the epitaxial wafer and the transparent substrate being bonded via an adhesive layer with both visible light-transmissive and ultraviolet light non-transmissive, wherein
a protruding height of a spike-shaped inclusion, which is inherently present in the epitaxial layer, from the epitaxial layer is equal to or less than a thickness of the adhesive layer, and
a tip portion of the spike-shaped inclusion is fractured.

2. The bonded light-emitting device wafer according to claim 1, wherein
the adhesive layer is selected from the group consisting of benzocyclobutene, silicone resin, epoxy resin, SOG, polyimide, and amorphous fluoropolymer.

3. A method for producing a bonded light-emitting device wafer, the method comprising the steps of:
producing an epitaxial wafer for a light-emitting device having an epitaxial layer including an active layer on a starting substrate;
providing a transparent substrate with both visible light-transmissive and ultraviolet light-transmissive; and
bonding the epitaxial wafer for the light-emitting device and the transparent substrate via an adhesive layer with both visible light-transmissive and ultraviolet light non-transmissive, wherein
before the step of bonding, the epitaxial layer of the epitaxial wafer is faced to a dummy wafer via a protective film, and pressure is applied thereon,
a tip portion of a protruding portion from the epitaxial layer of a spike-shaped inclusion inherently present in the epitaxial layer is then fractured to a protruding height from the epitaxial layer equal to or less than a thickness of an adhesive layer, and the protruding height from the epitaxial layer of the spike-shaped inclusion is decreased, and
the step of bonding is performed by using the epitaxial wafer in which height of the spike-shaped inclusion from the epitaxial layer is decreased.

4. The method for producing a bonded light-emitting device wafer according to claim 3, wherein
the protective film has a thickness of 0.01 µm or more and 10 µm or less.

5. The method for producing a bonded light-emitting device wafer according to claim 4, wherein
the protective film has a thickness of 0.05 µm or more and 10 µm or less.

6. The method for producing a bonded light-emitting device wafer according to any one of claims 3 to 5, wherein
the adhesive layer is selected from the group consisting of benzocyclobutene, silicone resin, epoxy resin, SOG, polyimide, and amorphous fluoropolymer.
